(19) Europäisches Patentamt
European Patent Office
Office européen des brevets

(11) **EP 4 697 032 A1**

(12) **EUROPEAN PATENT APPLICATION**
published in accordance with Art. 153(4) EPC

(43) Date of publication:
**18.02.2026 Bulletin 2026/08**

(21) Application number: **24788026.3**

(22) Date of filing: **08.04.2024**

(51) International Patent Classification (IPC):
*G01R 19/00* (2006.01)    *H02M 3/156* (2006.01)

(52) Cooperative Patent Classification (CPC):
Y02B 70/10

(86) International application number:
**PCT/CN2024/086573**

(87) International publication number:
**WO 2024/212923 (17.10.2024 Gazette 2024/42)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.04.2023 CN 202310375321**

(71) Applicant: **Vanchip (Tianjin) Technology Co. Ltd Tianjin 300457 (CN)**

(72) Inventors:
• **LI, Songke**
  **Tianjin 300457 (CN)**
• **WANG, Yongshou**
  **Tianjin 300457 (CN)**

(74) Representative: **Wang, Bo**
  **Panovision IP**
  **Ebersberger Straße 3**
  **85570 Markt Schwaben (DE)**

(54) **LOAD CURRENT MEASUREMENT CIRCUIT AND METHOD FOR BUCK-TYPE DC-DC CONVERTER**

(57) A load current measurement circuit and method for a buck-type DC-DC converter. The load current measurement circuit comprises a switch current measurement unit (101), a freewheeling current compensation unit (102) and a signal averaging processing unit (103), wherein two input ends of the switch current measurement unit (101) are respectively coupled to an input voltage end and a connection node of a power switch and a freewheeling diode, and the switch current measurement unit (101) is used for measuring the current of the power switch when the power switch is turned on and the freewheeling diode is turned off, and for obtaining the measured current; two input ends of the freewheeling current compensation unit (102) are respectively coupled to an output voltage end and a ground potential end, and the freewheeling current compensation unit (102) processes an output voltage to obtain a compensation current; and two input ends of the signal averaging processing unit (103) are respectively connected to an output end of the switch current measurement unit (101) and an output end of the freewheeling current compensation unit (102), and the signal averaging processing unit (103) is used for performing averaging processing on the measured current and the compensation current to obtain a load current.

FIG. 2

**Description**

**BACKGROUND**

**Technical Field**

The present invention relates to a load current measurement circuit for a Buck-type DC-DC converter and a Buck-type DC-DC converter including the load current measurement circuit, further relates to a corresponding load current measurement method, and belongs to the field of analog integrated circuit technologies.

**Related Art**

With the continuous development of integrated circuit technologies, DC-DC converters are increasingly widely used in integrated circuits due to excellent performance such as high efficiency. Requirements on the DC-DC converters in various electronic products such as smartphones and tablet computers are also becoming higher. In actual application, a power switch current usually needs to be measured to obtain an inductance peak current for loop control and circuit protection, and a load current further needs to be measured to implement precise control.

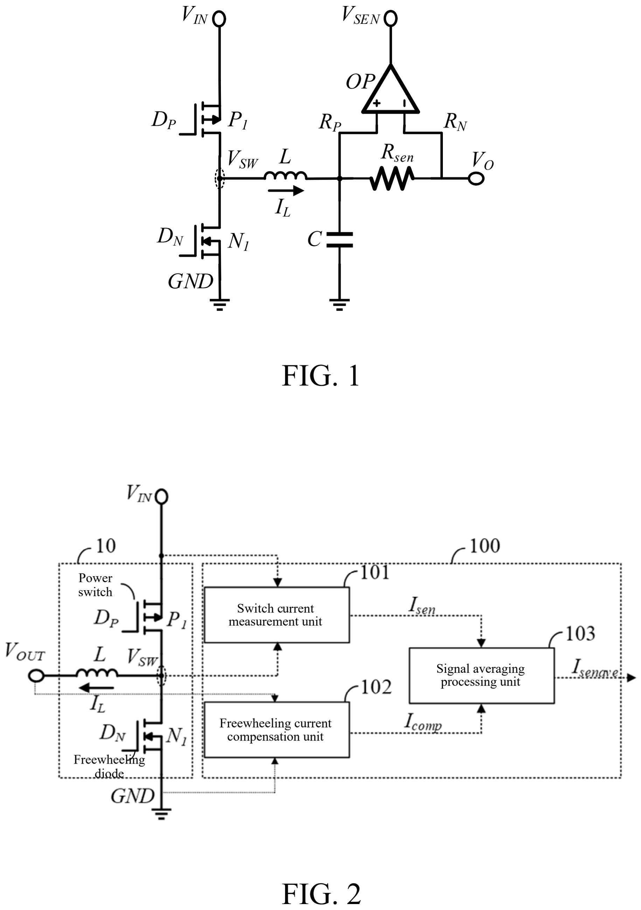

In a conventional technology, a load current measurement solution for a DC-DC converter is usually shown in FIG. 1. A measurement resistor Rsen is connected in series to a current path of a switch power supply. When a current flows through the measurement resistor Rsen, a voltage drop Vsen is generated. Voltage drops Vsen on two ends of the measurement resistor are processed by using an operational amplifier OP to obtain load current information. In this measurement solution, power is consumed because the measurement resistor is connected in series to the current path, resulting in a loss of efficiency of the converter. In addition, a temperature rise caused by power consumption on the measurement resistor may change a resistance value of the measurement resistor, affecting sampling precision. If the resistance value of the measurement resistor is reduced, the voltage drops on the two ends of the measurement resistor are smaller, and the operational amplifier needs to have higher precision to process this signal. In addition, an equivalent series resistor (DCR) of an inductor may be used to measure an inductance current without increasing losses, but the equivalent series resistor of the inductor actually varies due to different inductor models and batches, and therefore measurement precision is also affected. In a Buck-type DC-DC converter, if a chip-integrated load current sampling technology is used to obtain an inductance current, sampling and processing further need to be performed on a current of a freewheeling diode. Therefore, a freewheeling current measurement circuit further needs to be added on the basis of the measurement of the power switch current, making a measurement circuit more complex.

**SUMMARY**

A primary technical problem addressed by the present invention is to provide a load current measurement circuit for a Buck-type DC-DC converter.

Another technical problem addressed by the present invention is to provide a Buck-type DC-DC converter including the load current measurement circuit.

Still another technical problem addressed by the present invention is to provide a load current measurement method for a Buck-type DC-DC converter.

To achieve the foregoing objectives, the present invention uses the following technical solutions:

According to a first aspect of embodiments of this application, a load current measurement circuit for a Buck-type DC-DC converter is provided, including a switch current measurement unit, a freewheeling current compensation unit, and a signal averaging processing unit, where

a first input end of the switch current measurement unit is coupled to an input voltage end, a second input end of the switch current measurement unit is coupled to a connection node between a power switch and a freewheeling diode, and the switch current measurement unit is configured to: when the power switch is turned on and the freewheeling diode is turned off, measure a power switch current and obtain a measured current proportional to the power switch current;

a first input end of the freewheeling current compensation unit is coupled to an output voltage end, a second input end of the freewheeling current compensation unit is coupled to a ground potential end, and the freewheeling current compensation unit is configured to obtain, after processing the output voltage, a freewheeling diode compensation current proportional to an output voltage; and

a first input end of the signal averaging processing unit is connected to an output end of the switch current measurement unit, a second input end of the signal averaging processing unit is connected to an output end of the freewheeling current compensation unit, and the signal averaging processing unit is configured to obtain a load current after performing averaging processing on the measured current and the compensation current.

Preferably, the switch current measurement unit includes a first PMOS transistor, a second PMOS transistor, a third PMOS transistor, a fourth PMOS transistor, a fifth PMOS transistor, a sixth PMOS transistor, a first NMOS transistor, a second NMOS transistor, and a first inverter, where a source of the second PMOS transistor and a source of the third PMOS transistor are connected to the input voltage end, and a source of the first PMOS transistor is connected to the connection node between the power switch and the freewheeling diode; a gate of the first PMOS transistor is connected to a first control signal end and connected, through the first inverter, to a gate of the second PMOS transistor, a drain of the first PMOS transistor and a drain of the second PMOS transistor are connected to each other and then are jointly connected to a source of the fourth PMOS transistor, a drain of the fourth PMOS transistor is connected to a drain of the first NMOS transistor and a gate of the sixth PMOS transistor, a source of the first NMOS transistor is connected to the ground potential end, and a gate of the first NMOS transistor is connected to a bias voltage end; a gate of the fourth PMOS transistor is connected to a gate of the fifth PMOS transistor, the gate of the fifth PMOS transistor is short-circuited to a drain of the fifth PMOS transistor and then connected to a drain of the second NMOS transistor, a source of the second NMOS transistor is connected to the ground potential end, and a gate of the second NMOS transistor is connected to the bias voltage end; a source of the fifth PMOS transistor is connected to a drain of the third PMOS transistor and connected to a source of the sixth PMOS transistor; and a gate of the third PMOS transistor is connected to the ground potential end, and a drain of the sixth PMOS transistor is connected to the output end of the switch current measurement unit.

Preferably, the measured current Isen outputted by the switch current measurement unit satisfies the following formula:

$$I_{sen} = K_1 * I_{P1}$$

where $I_{P1}$ is the power switch current when the power switch is turned on, and $K_1$ is a power switch current measurement proportional coefficient.

Preferably, the freewheeling current compensation unit includes a first operational amplifier, a seventh PMOS transistor, an eighth PMOS transistor, a third NMOS transistor, a fourth NMOS transistor, a fifth NMOS transistor, a first resistor, a second resistor, and a third resistor, where one end of the first resistor is connected to the output voltage end, the other end of the first resistor is connected to the second resistor and an in-phase input end of the first operational amplifier, and the other end of the second resistor is connected to the ground potential end; an output end of the first operational amplifier is connected to a gate of the third NMOS transistor, a reverse-phase input end of the first operational amplifier is connected to a source of the third NMOS transistor and the third resistor, and the other end of the third resistor is connected to the ground potential end; and a drain of the third NMOS transistor is connected to a drain of the seventh PMOS transistor, the drain of the seventh PMOS transistor is short-circuited to a gate of the seventh PMOS transistor and then connected to a gate of the eighth PMOS transistor, a source of the seventh PMOS transistor is connected to a source of the eighth PMOS transistor, a drain of the eighth PMOS transistor is connected to a drain of the fourth NMOS transistor, the drain of the fourth NMOS transistor is short-circuited to a gate of the fourth NMOS transistor and then connected to a gate of the fifth NMOS transistor, a source of the fourth NMOS transistor and a source of the fifth NMOS transistor are both connected to the ground potential end, and a drain of the fifth NMOS transistor is connected to the output end of the freewheeling current compensation unit.

Preferably, the compensation current Icomp outputted by the freewheeling current compensation unit satisfies the following formula:

$$I_{comp} = K_2 * V_{out}$$

where Vout is the output voltage, and $K_2$ is a proportional coefficient between the compensation current and the output voltage.

Preferably, the signal averaging processing unit includes a sample-and-hold module, a unity gain buffer module, a low-pass filter module, a voltage-to-current conversion module, a first bias current source, and a second bias current source, where

the sample-and-hold module generates a measured voltage according to the measured current, the compensation current, and a first bias current source current; after the measured voltage undergoes voltage buffering of the unity gain buffer module and low-pass filtering of the low-pass filter module, an average voltage is generated; and after the average voltage is converted into a current signal through the voltage-to-current conversion module, bias current information is removed through a second bias current source current, to obtain the load current.

Preferably, in the signal averaging processing unit, the sample-and-hold module is formed by a sampling resistor, a sampling capacitor, a first switch, and a second switch; the unity gain buffer module includes a second operational amplifier; and the low-pass filter module includes a filter resistor and a filter capacitor, where

the output end of the switch current measurement unit and an output end of the first bias current source are jointly connected to the sampling resistor and the first switch, and the other end of the sampling resistor is connected to the ground potential end; the other end of the first switch is connected to the sampling capacitor, the second switch, and an in-phase input end of the second operational amplifier, the other end of the sampling capacitor is connected to the ground potential end, and the other end of the second switch is connected to the output end of the freewheeling current compensation unit; a reverse-phase input end and an output end of the second operational amplifier are short-circuited and then are jointly connected to the filter resistor, the other end of the filter resistor is connected to the filter capacitor and an input end of the voltage-to-current conversion module, and the other end of the filter capacitor is connected to the ground potential end; and an output end of the voltage-to-current conversion module is connected to an input end of the second bias current source and an output end of the signal averaging processing unit, and an output end of the second bias current source is connected to the ground potential end; and
a control end of the first switch is connected to an inverted signal end of a first control signal, and a control end of the second switch is connected to a second control signal end.

Preferably, when the power switch of the Buck-type DC-DC converter is turned on and the freewheeling diode of the Buck-type DC-DC converter is turned off, a change amount $\Delta \text{Vsen1}$ of the measured voltage outputted by the sample-and-hold module satisfies the following formula:

$$\Delta V_{sen1} = K_1 * \frac{V_{in} - V_{out}}{L} * D_1 * T_s * R_s$$

where $K_1$ is a power switch current measurement proportional coefficient, Rs is a resistance value of the sampling resistor, D1 is a duty cycle of the power switch, Ts is a switch cycle, Vin is an input voltage, Vout is the output voltage, and L is an inductance value of an inductor.

Preferably, when the power switch of the Buck-type DC-DC converter is turned off and the freewheeling diode of the Buck-type DC-DC converter is turned on, a change amount $\Delta \text{Vsen2}$ of the measured voltage outputted by the sample-and-hold module satisfies the following formula:

$$\Delta V_{sen2} = \frac{K_2 * V_{out} * D_2 * T_s}{C_s}$$

where $K_2$ is a proportional coefficient between the compensation current and the output voltage, $D_2$ is a duty cycle of the freewheeling diode, Ts is a switch cycle, Cs is a capacitance value of the sampling capacitor, and Vout is the output voltage.

Preferably, the power switch current measurement proportional coefficient $K_1$ and the proportional coefficient $K_2$ between the compensation current and the output voltage satisfy the following formula:

$$K_2 = \frac{K_1 * C_s * R_s}{L}$$

where Cs is the capacitance value of the sampling capacitor, Rs is the resistance value of the sampling resistor, and L is the inductance value of the inductor.

Preferably, in the signal averaging processing unit, an output current Ibias1 of the first bias current source and an output current Ibias2 of the second bias current source satisfy the following formula:

$$Ibias1*Rs*K3=Ibias2$$

where K3 is a conversion proportional coefficient of the voltage-to-current conversion module, and Rs is a resistance value of the sampling resistor.

According to a second aspect of the embodiments of the present invention, a Buck-type DC-DC converter is provided, including the foregoing load current measurement circuit.

According to a third aspect of the embodiments of the present invention, a load current measurement method for a Buck-type DC-DC converter is provided, implemented based on the foregoing load current measurement circuit, and including the following steps:

measuring a power switch current in a turn-on period of the power switch, to form a measured current;

generating, after sample-and-hold processing is performed on the measured current and a bias current source, a measured voltage proportional to an inductance current in an inductance current rising phase;

measuring an output voltage in a turn-on period of the freewheeling diode, to form a compensation current;

generating, after sample-and-hold processing is performed on the compensation current, the measured current, and the bias current source, a measured voltage proportional to the inductance current in an inductance current decreasing phase;

performing averaging processing on the measured voltage to obtain an average voltage; and

converting the average voltage into a current signal and then removing bias current information to obtain a load current.

Compared with the prior art, a load current measurement circuit for a Buck-type DC-DC converter provided in the present invention resolves a problem of parameter sensitivity of external inductance components by using an on-chip current measurement technical solution without increasing losses, thereby improving reliability of a measurement circuit. In addition, on the basis of power switch current measurement, compensation processing is performed on a freewheeling diode compensation current, to obtain an inductance current measurement signal in an entire switch cycle, and average processing is performed on the inductance current measurement signal to obtain a load current, so that measurement of the load current is implemented without adding a freewheeling diode measurement circuit. Therefore, the load current measurement circuit for a Buck-type DC-DC converter provided in the present invention has beneficial effects including a clever and proper structural design, lower design costs, and high measurement precision.

## BRIEF DESCRIPTION OF THE DRAWINGS

FIG. 1 is a diagram of a load current measurement solution for a DC-DC converter according to the prior art;

FIG. 2 is a structural block diagram of a load current measurement circuit for a Buck-type DC-DC converter according to the present invention;

FIG. 3 is a schematic diagram of an inductance current of a Buck-type DC-DC converter in a CCM mode and an FCCM mode according to an embodiment of the present invention;

FIG. 4 is a schematic diagram of an inductance current of a Buck-type DC-DC converter in a DCM mode according to an embodiment of the present invention;

FIG. 5 is a diagram of a measurement principle of a load current of a Buck-type DC-DC converter according to an embodiment of the present invention;

FIG. 6 is a diagram of a circuit principle of a switch current measurement unit according to an embodiment of the present invention;

FIG. 7 is a diagram of a circuit principle of a freewheeling current compensation unit according to an embodiment of the present invention;

FIG. 8 is a structural block diagram of a signal averaging processing unit according to an embodiment of the present invention;

FIG. 9 is a diagram of a circuit principle of a signal averaging processing unit according to an embodiment of the present invention;

FIG. 10 is a time sequence comparison diagram of a Buck-type DC-DC converter operating in a CCM mode according to an embodiment of the present invention;

FIG. 11 is a time sequence comparison diagram of a Buck-type DC-DC converter operating in a DCM mode according to an embodiment of the present invention; and

FIG. 12 is an operating flowchart of a load current measurement circuit for a Buck-type DC-DC converter according to the present invention.

## DETAILED DESCRIPTION

The following describes the technical content of the present invention in detail with reference to accompanying drawings and specific embodiments.

As shown in FIG. 2, a load current measurement circuit 100 for a Buck-type DC-DC converter provided in the present invention includes a switch current measurement unit 101, a freewheeling current compensation unit 102, and a signal averaging processing unit 103.

A first input end of the switch current measurement unit 101 is coupled to an input voltage end $V_{IN}$, a second input end of the switch current measurement unit 101 is coupled to a connection node $V_{SW}$ between a power switch P1 and a freewheeling diode N1, and the switch current measurement unit 101 is configured to: when the power switch P1 is turned on and the freewheeling diode N1 is turned off, measure a current flowing through the power switch P1 and obtain a measured current Isen proportional to the current of the power switch P1;

a first input end of the freewheeling current compensation unit 102 is coupled to an output voltage end $V_{OUT}$, a second input end of the freewheeling current compensation unit 102 is coupled to a ground potential end, and the freewheeling current compensation unit 102 is configured to obtain, after processing the output voltage, a freewheeling diode compensation current Icomp proportional to an output voltage; and
a first input end of the signal averaging processing unit 103 is connected to an output end of the switch current measurement unit 101, a second input end of the signal averaging processing unit 103 is connected to an output end of the freewheeling current compensation unit 102, and the signal averaging processing unit 103 is configured to obtain a load current after performing averaging processing on the measured current Isen and the compensation current Icomp.

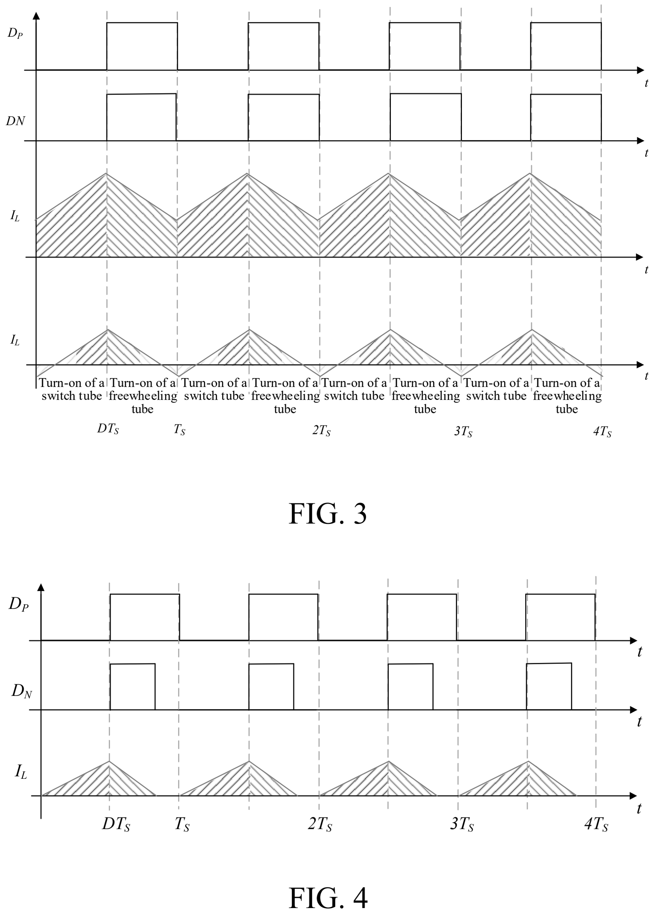

In the Buck-type DC-DC converter, as shown in FIG. 3, the power switch P1 and the freewheeling diode N1 are alternately turned on throughout an entire switch cycle $T_S$. In a period from 0 to $D*T_s$, the power switch P1 is turned on, and an inductance current $I_L$ rises with a slope of $\dfrac{V_{in}-V_{out}}{L}$; at a moment $D*T_s$, the power switch P1 is turned off, and the inductance current $I_L$ reaches a peak value; and in a period from $D*T_s$ to $T_s$, the freewheeling diode N1 is turned on, and the inductance current $I_L$ decreases with a slope of $\dfrac{V_{out}}{L}$ until the current switch cycle $T_s$ ends. L is an inductance value, Ts is the switch cycle, D is a duty cycle, Vout is the output voltage, and Vin is an input voltage.

According to a magnitude of the load current and a control solution of the power switch, the Buck-type DC-DC converter may have three operating conditions, and a change condition of the inductance current $I_L$ is as follows.

A first operating condition is that when the load current is large, the DC-DC converter operates in a continuous conduction mode (CCM), and the inductance current $I_L$ continuously includes a rising phase and a decreasing phase in the switch cycle Ts, and does not fall below zero.

A second operating condition is that under a light load condition, the DC-DC converter operates in a forced continuous conduction mode (FCCM), and the inductance current $I_L$ continuously includes a rising phase and a decreasing phase in the switch cycle Ts, and is allowed to fall below zero.

A third operating condition is that under a light load condition, the DC-DC converter operates in a discontinuous conduction mode (DCM). As shown in FIG. 4, if the inductance current $I_L$ is measured to be greater than zero, the freewheeling diode N1 is turned off, so that the inductance current $I_L$ is kept to zero. In other words, the inductance current $I_L$ includes a rising phase, a decreasing phase, and a zero phase in one switch cycle.

Under the foregoing three operating conditions, in N switch cycles $T_s$, a total charge amount delivered to load in turn-on periods of the power switch P1 and the freewheeling diode N1 is divided by a total switch time $N*T_s$ to obtain an average value of the load current.

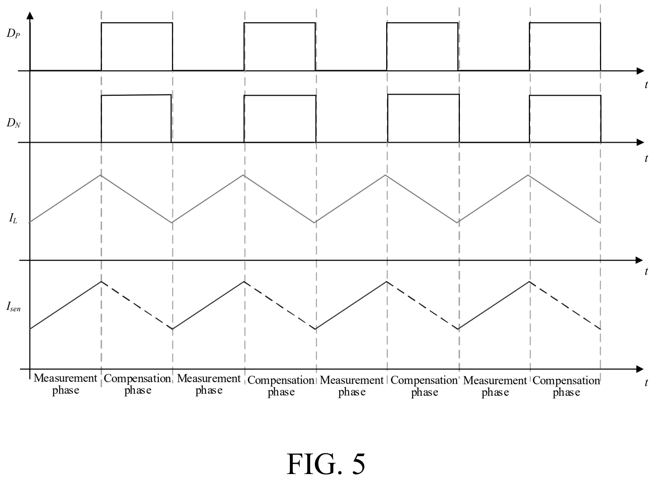

As shown in FIG. 5, a basic principle of load current measurement of the Buck-type DC-DC converter in the present invention is as follows. In the switch cycle Ts, the inductance current $I_L$ is measured in the turn-on period of the power switch P1, an inductance current peak value in this period is stored, and compensation processing is performed on the peak current in the turn-on period of the freewheeling diode N1, so that a change of a compensated current signal is consistent with a change of the inductance current in the turn-on period of the freewheeling diode N1, and a load current signal consistent with the inductance current in the entire switch cycle can be obtained.

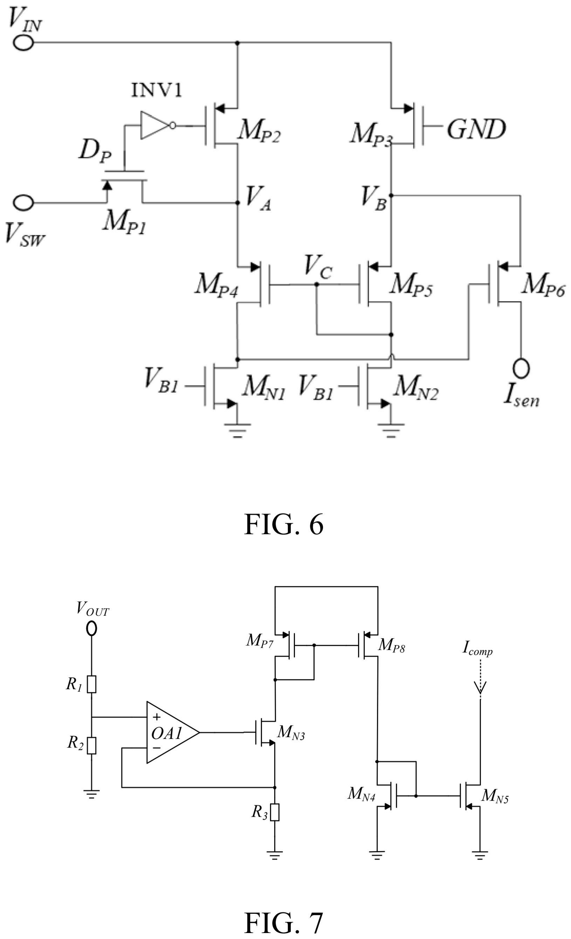

In an embodiment of the present invention, as shown in FIG. 6, the switch current measurement unit 101 includes a first PMOS transistor MP1, a second PMOS transistor MP2, a third PMOS transistor MP3, a fourth PMOS transistor MP4, a fifth PMOS transistor MP5, a sixth PMOS transistor MP6, a first NMOS transistor MN1, a second NMOS transistor MN2, and a first inverter INV1. A source of the second PMOS transistor MP2 and a source of the third PMOS transistor MP3 are connected to the input voltage end $V_{IN}$, and a source of the first PMOS transistor MP1 is connected to the connection node $V_{sw}$ between the power switch P1 and the freewheeling diode N1; a gate of the first PMOS transistor MP1 is connected to a first control signal $D_p$ end and connected, through the first inverter INV1, to a gate of the second PMOS transistor MP2, a drain of the first PMOS transistor MP1 and a drain of the second PMOS transistor MP2 are connected to each other (a node $V_A$) and then are jointly connected to a source of the fourth PMOS transistor MP4, a drain of the fourth PMOS transistor MP4 is connected to a drain of the first NMOS transistor MN1 and a gate of the sixth PMOS transistor MP6, a source of the first NMOS transistor MN1 is connected to the ground potential end, and a gate of the first NMOS transistor MN1 is connected to a bias voltage $V_{B1}$ end; a gate (a node $V_C$) of the fourth PMOS transistor MP4 is connected to a gate of the fifth PMOS transistor MP5, the gate of the fifth PMOS transistor MP5 is short-circuited to a drain of the fifth PMOS transistor MP5 and then connected to a drain of the second NMOS transistor MN2, a source of the second NMOS transistor MN2 is connected to the ground potential end, and a gate of the second NMOS transistor MN2 is connected to the bias voltage $V_{B1}$ end; a source (a node $V_B$) of the fifth PMOS transistor MP5 is connected to a drain of the third PMOS transistor MP3 and connected to a source of the sixth PMOS transistor MP6; and a gate of the third PMOS transistor MP3 is connected to the ground potential end, and a drain of the sixth PMOS transistor MP6 is connected to the output end of the switch current measurement unit.

In the switch current measurement unit 101, assuming that width-to-length ratios of the first PMOS transistor MP1, the second PMOS transistor MP2, and the third PMOS transistor MP3 are the same, width-to-length ratios of the fourth PMOS transistor MP4 and the fifth PMOS transistor MP5 are the same, and width-to-length ratios of the first NMOS transistor MN1 and the second NMOS transistor MN2 are the same, a relationship between the measured current Isen at the output end and a power switch current $I_{P1}$ satisfies:

$$I_{sen} = \frac{R_{onp}}{R_{MP3}} * I_{P1} \qquad (1)$$

Ronp is a turn-on resistance of the power switch P1, and $R_{MP3}$ is a turn-on resistance of the third PMOS transistor MP3, and $I_{P1}$ is a current flowing through the power switch P1 when the power switch P1 is turned on.

In the formula 1, when a power switch current measurement proportional coefficient $K_1$ is Ronp/$R_{MP3}$, the measured current Isen is:

$$I_{sen} = K_1 * I_{P1} \qquad (2)$$

$K_1$ is a power switch current measurement proportional coefficient.

In an embodiment of the present invention, as shown in FIG. 7, the freewheeling current compensation unit 102 includes a first operational amplifier OA1, a seventh PMOS transistor MP7, an eighth PMOS transistor MP8, a third NMOS transistor MN3, a fourth NMOS transistor MN4, a fifth NMOS transistor MN5, a first resistor R1, a second resistor R2, and a third resistor R3. One end of the first resistor R1 is connected to the output voltage end $V_{OUT}$, the other end of the first resistor R1 is connected to the second resistor R2 and an in-phase input end of the first operational amplifier OA1, and the other end of the second resistor R2 is connected to the ground potential end; an output end of the first operational amplifier OA1 is connected to a gate of the third NMOS transistor MN3, a reverse-phase input end of the first operational amplifier OA1 is connected to a source of the third NMOS transistor MN3 and the third resistor R3, and the other end of the third resistor R3 is connected to the ground potential end; and a drain of the third NMOS transistor MN3 is connected to a drain of the seventh PMOS transistor MP7, the drain of the seventh PMOS transistor MP7 is short-circuited to a gate of the seventh PMOS transistor MP7 and then connected to a gate of the eighth PMOS transistor MP8, a source of the seventh PMOS transistor MP7 is connected to a source of the eighth PMOS transistor MP8, a drain of the eighth PMOS transistor MP8 is connected to a drain of the fourth NMOS transistor MN4, the drain of the fourth NMOS transistor MN4 is short-circuited to a gate of the fourth NMOS transistor MN4 and then connected to a gate of the fifth NMOS transistor MN5, a source of the fourth NMOS transistor MN4 and a source of the fifth NMOS transistor MN5 are both connected to the ground potential end, and a drain of the fifth NMOS transistor MN5 is connected to the output end of the freewheeling current compensation unit.

In the freewheeling current compensation unit 102, assuming width-to-length ratios of the seventh PMOS transistor MP7 and the eighth PMOS transistor MP8 are the same, and width-to-length ratios of the fourth NMOS transistor MN4 and the fifth NMOS transistor MN5 are the same, a relationship between the compensation current Icomp at the output end and the output voltage Vout satisfies:

$$I_{comp} = \frac{R_2}{(R_1+R_2)R_3} V_{out} \qquad (3)$$

R1, R2, and R3 are respectively resistance values of the first resistor R1, the second resistor R2, and the third resistor R3.

In the formula 3, when a proportional coefficient K2 of the compensation current Icomp to the output voltage Vout is $\frac{R_2}{(R_1+R_2)R_3}$ , the compensation current Icomp is

$$I_{comp} = K_2 * V_{out} \qquad (4)$$

$K_2$ is a proportional coefficient between the compensation current Icomp and the output voltage Vout.

From the operating principle of the Buck-type DC-DC converter, it can be learned that in the turn-on period of the freewheeling diode, a decreasing slope of the inductance current is Vout/L, and the decreasing slope is directly proportional to the output voltage. Therefore, the compensation current Icomp can represent a change rate of the inductance current in the turn-on period of the freewheeling diode.

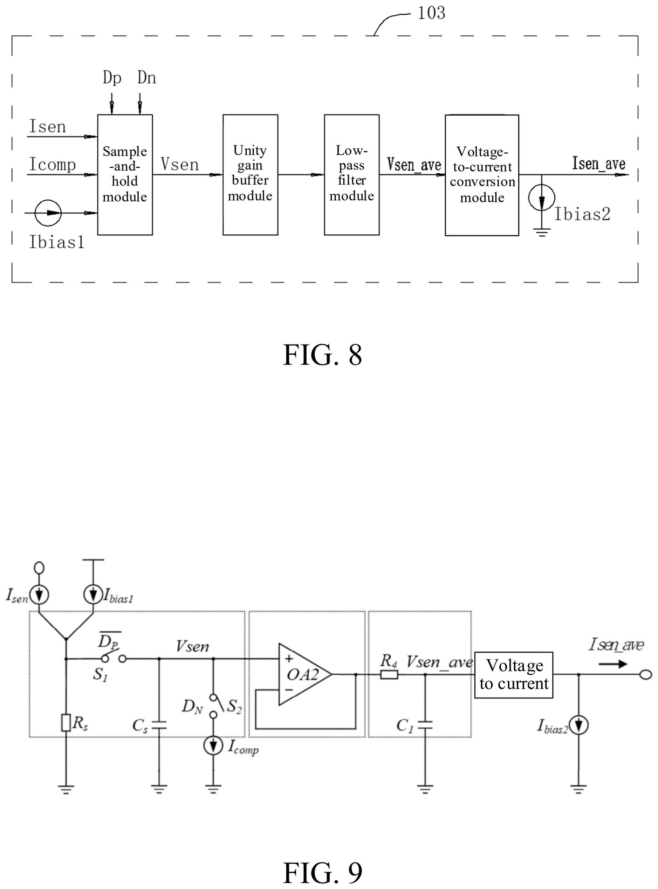

In an embodiment of the present invention, as shown in FIG. 8, the signal averaging processing unit 103 includes a sample-and-hold module, a unity gain buffer module, a low-pass filter module, a voltage-to-current conversion module, a first bias current source Ibias1, and a second bias current source Ibias2. The output end of the switch current measurement unit 101, the output end of the freewheeling current compensation unit 102, and an output end of the first bias current source Ibias1 are connected to an input end of the sample-and-hold module. An output end of the sample-and-hold module is connected to an input end of the unity gain buffer module. An output end of the unity gain buffer module is connected to an input end of the low-pass filter module. An output end of the low-pass filter module is connected to an input end of the voltage-to-current conversion module. An output end of the voltage-to-current conversion module is connected to an input end of the second bias current source Ibias2 and the output end of the signal averaging processing unit. An output end of the second bias current source Ibias2 is connected to the ground potential end.

In the signal averaging processing unit 103, the sample-and-hold module generates an output voltage Vsen according to the input measured current Isen, the input compensation current Icomp, and the first bias current source current Ibias1 under control of a power switch control signal $D_P$ and a freewheeling diode control signal $D_N$; after the voltage Vsen undergoes voltage buffering and low-pass filtering, an average voltage Vsen_ave in the entire switch cycle is formed; and further, after the average voltage Vsen_ave is converted into a current, bias current information is removed through the second bias current source current Ibias2, to obtain a load current Isen_ave, that is, the measured current outputted by the load current measurement circuit 100 for a Buck-type DC-DC converter. A characteristic time constant of the low-pass filter module including a filter resistor and a filter capacitor is not less than a switch cycle of a switch power supply.

In an embodiment of the present invention, a specific circuit of the signal averaging processing unit 103 is shown in FIG. 9, including a sample-and-hold module including a sampling resistor Rs, a sampling capacitor Cs, a first switch S1, and a second switch S2, a unity gain buffer module including a second operational amplifier OA2, a low-pass filter module including a filter resistor R4 and a filter capacitor C1, a voltage-to-current conversion module, a first bias current source Ibias1, and a second bias current source Ibias2. The output end of the switch current measurement unit 101 and an output end of the first bias current source Ibias1 are jointly connected to the sampling resistor Rs and the first switch S1, and the other end of the sampling resistor Rs is connected to the ground potential end; the other end of the first switch S1 is connected to the sampling capacitor Cs, the second switch S2, and an in-phase input end of the second operational amplifier OA2, the other end of the sampling capacitor Cs is connected to the ground potential end, and the other end of the second switch S2 is connected to the output end of the freewheeling current compensation unit 102; a reverse-phase input end and an output end of the second operational amplifier OA2 are short-circuited and then are jointly connected to the filter resistor R4, the other end of the filter resistor R4 is connected to the filter capacitor C1 and an input end of the voltage-to-current conversion module, and the other end of the filter capacitor C1 is connected to the ground potential end; and an output end of the voltage-to-current conversion module is connected to an input end of the second bias current source Ibias2 and an output end of the signal averaging processing unit, and an output end of the second bias current source Ibias2 is connected to the ground potential end. A control end of the first switch S1 is connected to an inverted signal end of a first control signal $D_P$, and a control end of the second switch S2 is connected to a second control signal $D_N$ end.

When the Buck-type DC-DC converter operates in the forced continuous conduction mode (FCCM), the inductance current $I_L$ may become negative. Therefore, the bias current Ibias1 is added to the input end of the sample-and-hold module on the basis of the measured current Isen, so that a current signal in a period of a negative inductance current $I_L$ can be accurately stored on the sampling capacitor Cs, to ensure accurate measurement of the load current when the Buck-type DC-DC converter operates in all the three operating conditions.

An operating process of the signal averaging processing unit 103 is as follows:
In the Buck-type DC-DC converter, when the power switch P1 is turned on and the freewheeling diode N1 is turned off, the power switch control signal $D_P$=0 and the freewheeling diode control signal $D_N$=0. Therefore, $\overline{D_P}=1$, the first switch S1 is turned on, and the second switch S2 is turned off. After the measured current Isen of the power switch P1 and the first bias current Ibias1 pass through the sampling resistor Rs and the sampling capacitor Cs, the measured voltage Vsen is generated at the output end of the sample-and-hold module. The voltage Vsen satisfies the following formula:

$$C_s \frac{dV_{sen}}{dt} + \frac{V_{sen}}{R_s} = K_1 * I_{P1} + I_{bias1} \qquad (5)$$

When $C_s \ll T_s/R_s$, the foregoing formula may be simplified to:

$$V_{sen} = (K_1 * I_{P1} + I_{bias1}) * R_s \qquad (6)$$

$K_1$ is the power switch current measurement proportional coefficient, $I_{P1}$ is the current flowing through the power switch P1 when the power switch P1 is turned on, Ibias1 is an output current of the first bias current source Ibias1, and Rs is a resistance value of the sampling resistor Rs.

A change amount $\Delta I$ of the inductance current $I_L$ in the turn-on period of the power switch P1 is:

$$\Delta I = \frac{V_{in} - V_{out}}{L} \times D_1 \times T_s \qquad (7)$$

From the formula 6 and the formula 7, it can be learned that in the turn-on period of the power switch P1, a change amount $\Delta Vsen1$ of the measured voltage Vsen at the output end of the sample-and-hold module is:

$$\Delta V_{sen1} = K_1 * \frac{V_{in} - V_{out}}{L} * D_1 * T_s * R_s \qquad (8)$$

D1 is a duty cycle of the control signal $D_P$ of the power switch P1. Ts is the switch cycle, Vout is the output voltage, and Vin is the input voltage.

At D1*Ts, the power switch P1 is turned off, the freewheeling diode N1 is turned on, the power switch control signal $D_P$=1, and the freewheeling diode control signal $D_N$=1. Therefore, $\overline{Dp}$=0, the first switch S1 is turned off, and the second switch S2 is turned on. In this case, the inductance peak value current in the turn-on period of the power switch P1 is stored on the sampling capacitor Cs. In the subsequent turn-on period of the freewheeling diode N1, the sampling capacitor Cs discharges through the second switch S2 to the freewheeling current compensation unit. The compensation current Icom removes charge from the sampling capacitor Cs, causing the voltage Vsen to decrease linearly. In the turn-on period of the freewheeling diode N1, based on charge conservation, a change amount $\Delta Vsen2$ of the measured voltage Vsen at the output end of the sample-and-hold module is as follows:

$$\Delta V_{sen2} = \frac{K_2 * V_{out} * D_2 * T_s}{C_s} \qquad (9)$$

D2 is a duty cycle of the control signal $D_N$ of the freewheeling diode N1, Ts is the switch cycle, Vout is the output voltage, Cs is a capacitance value of the sampling capacitor Cs, and $K_2$ is the proportion coefficient between the compensation current Icom and the output voltage Vout.

If the Buck-type DC-DC converter operates in the DCM mode, in one switch cycle Ts, there is a phase in which both the power switch P1 and the freewheeling diode N1 are turned off. In this case, both the first switch S1 and the second switch S2 are turned off, and the voltage Vsen at the output end of the sample-and-hold module does not change.

In a circuit structure of the Buck-type DC-DC converter, based on the volt-second balance principle of an inductor, it can be learned that:

$$\frac{V_{in} - V_{out}}{V_{out}} = \frac{D_2}{D_1} \qquad (10)$$

To ensure that the compensation current Icom can properly compensate for the current change amount in the turn-on period of the freewheeling diode N1, the current or voltage change amount in the turn-on period of the power switch P1 should be equal to the current or voltage change amount in the turn-on period of the freewheeling diode N1. According to the formula 8 and the formula 9, it can be learned that:

$$\frac{K_1 * C_s * R_s}{L} * \frac{V_{In} - V_{out}}{V_{out}} = K_2 * \frac{D_2}{D_1} \qquad (11)$$

According to the formula 10, the formula 11 can be simplified to:

$$K_2 = \frac{K_1 * C_s * R_s}{L} \qquad (12)$$

From the formula 12, it can be learned that the proportional coefficient $K_2$ between the compensation current and the output voltage, the power switch current measurement proportional coefficient $K_1$, the sampling resistor Rs, and the sampling capacitor Cs should satisfy the relationship expressed in the formula 12.

After the measured voltage Vsen at the output end of the sample-and-hold module is compensated by using the compensation current Icom, a change trend of the measured voltage Vsen is consistent with a change trend of the inductance current in the turn-on period of the freewheeling diode N1, and the measured voltage Vsen satisfies the following formula:

$$V_{sen} = (K_1 * I_L + I_{bias1}) * R_s \qquad (13)$$

$I_L$ is the instance current, Ibias1 is the output current of the first bias current source Ibias1, and Rs is the resistance value of the sampling resistor Rs.

After the unity gain buffer module formed by the second operational amplifier OA2 buffers and outputs the voltage Vsen, and then performs averaging processing by using the low-pass filter module formed by the filter resistor R4 and the filter capacitor C1, to obtain the average voltage Vsen_ave. The average voltage includes current information of the first bias current source Ibias1. Therefore, after the current information is converted into a current signal by using the voltage-to-current conversion module and the bias current information is removed by using the second bias current source Ibias2, an average load current Isen_ave of the Buck-type DC-DC converter can be obtained.

The output current Ibias2 of the second bias current source Ibias2 and the output current Ibias1 of the first bias current source Ibias1 satisfy the following formula:

$$Ibias1*Rs*K3=Ibias2 \qquad (14)$$

K3 is a proportional coefficient of the voltage-to-current conversion module, and K3=output current/input voltage.

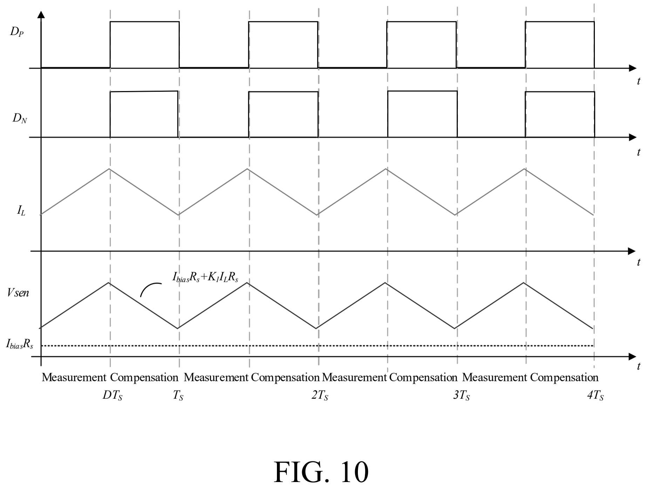

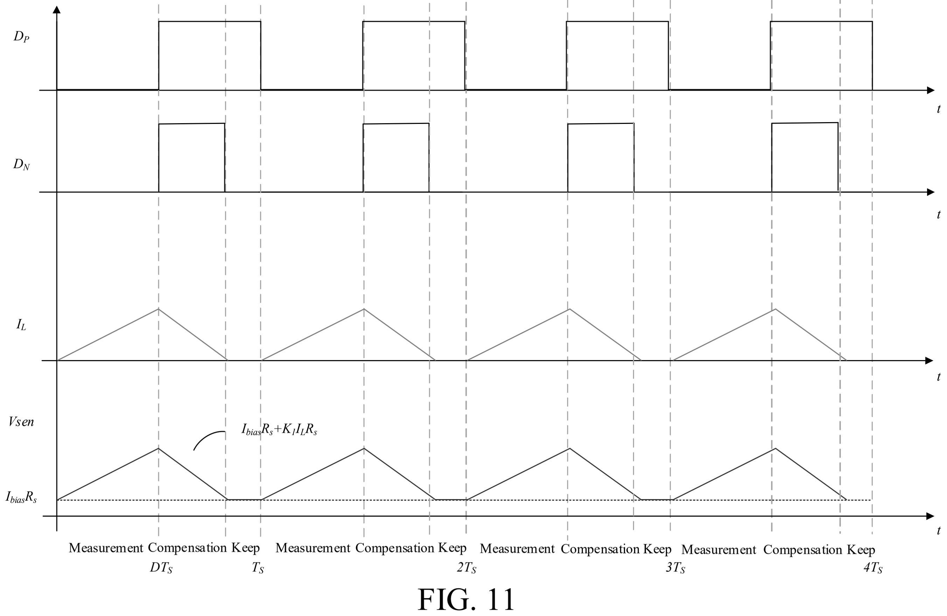

In the load current measurement circuit for a Buck-type DC-DC converter provided in the present invention, when the Buck-type DC-DC converter operates in the CCM mode or the DCM mode, time sequence comparisons of the power switch control signal $D_P$, the freewheeling diode control signal $D_N$, the inductance current $I_L$, and the voltage Vsen are shown in FIG. 10 and FIG. 11 respectively.

In FIG. 10, the Buck-type DC-DC converter operates in the CCM mode. When the power switch P1 is turned on and the freewheeling diode N1 is turned off, the switch current measurement unit 101 measures the current $I_{P1}$ flowing through the power switch P1 and generates the measured current Isen. In this case, the first switch S1 is turned on, the second switch S2 is turned off, and the signal averaging processing unit 103 converts the measured current Isen into the voltage Vsen by using the sampling resistor RS and stores the voltage Vsen on the sampling capacitor Cs. When the power switch P1 is turned off and the freewheeling diode N1 is turned on, the first switch S1 is turned off, the second switch S2 is turned on, and the compensation current Icom generated by the freewheeling current compensation unit 102 removes the charge from the sampling capacitor Cs, so that the voltage Vsen linearly decreases. When the compensation current Icom can properly compensate for the current change amount in the turn-on period of the freewheeling diode N1, a change of the voltage Vsen is consistent with a change of the inductance current $I_L$ in the turn-on period of the freewheeling diode N1.

In FIG. 11, the Buck-type DC-DC converter operates in the DCM mode. When both the power switch P1 and the freewheeling diode N1 are turned off, both the first switch S1 and the second switch S2 are turned off. The change of the measured voltage Vsen is consistent with the change of the inductance current $I_L$ in the entire switch cycle. Therefore, after averaging processing is performed on the measured voltage Vsen, the load current Isen_ave can be obtained.

In the load current measurement circuit for a Buck-type DC-DC converter provided in the present invention, the switch current measurement unit 101, the freewheeling current compensation unit 102, and the signal averaging processing unit 103 may alternatively be implemented by using various other specific circuit structures. This embodiment will not enumerate them one by one.

An embodiment of the present invention further provides a Buck-type DC-DC converter including the foregoing load current measurement circuit, and a measurement result is used for loop control, circuit protection, and the like. A specific structure of the load current measurement circuit in the Buck-type DC-DC converter is not described in detail herein again.

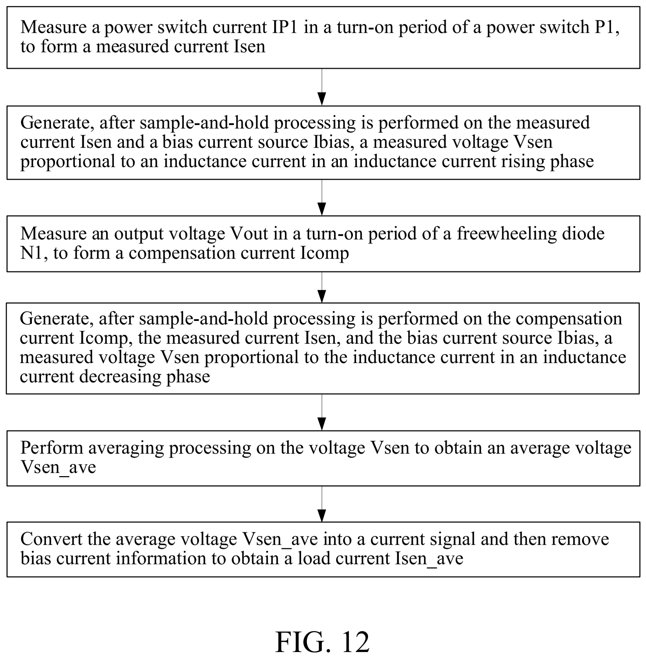

The load current measurement circuit for a Buck-type DC-DC converter provided in the present invention uses the method shown in FIG. 12 to implement load current measurement. An operating procedure in each switch cycle Ts is as follows:

S1: Measure a power switch current $I_{P1}$ in a turn-on period of a power switch P1, to form a measured current Isen.
S2: Generate, after sample-and-hold processing is performed on the measured current Isen and a bias current source Ibias, a measured voltage Vsen proportional to an inductance current in an inductance current rising phase.
S3: Measure an output voltage Vout in a turn-on period of a freewheeling diode N1, to form a compensation current Icomp.
S4: Generate, after sample-and-hold processing is performed on the compensation current Icomp, the measured current Isen, and the bias current source Ibias, a measured voltage Vsen proportional to the inductance current in an inductance current decreasing phase.

S5: Perform averaging processing on the measured voltage Vsen to obtain an average voltage Vsen_ave.

S6: Convert the average voltage Vsen_ave into a current signal and then remove bias current information to obtain a load current Isen_ave.

In the foregoing load current measurement method, parameters of circuit elements of units are set, so that a change of the measured voltage Vsen is consistent with a change of the inductance current $I_L$.

In conclusion, compared with the prior art, a load current measurement circuit for a Buck-type DC-DC converter provided in the present invention resolves a problem of parameter sensitivity of external inductance components by using an on-chip current measurement technical solution without increasing losses, thereby improving reliability of a measurement circuit. In addition, on the basis of power switch current measurement, compensation processing is performed on a freewheeling diode compensation current, to obtain an inductance current measurement signal in an entire switch cycle, and average processing is performed on the inductance current measurement signal to obtain a load current, so that measurement of the load current is implemented without adding a freewheeling diode measurement circuit. Therefore, the load current measurement circuit for a Buck-type DC-DC converter provided in the present invention has beneficial effects including a clever and proper structural design, lower design costs, and high measurement precision.

It should be noted that the foregoing plurality of embodiments are merely examples, and the technical solutions of the embodiments may be combined, all of which fall within the protection scope of the present invention.

In addition, the terms "first" and "second" are merely used for the purpose of description, and cannot be understood as indicating or implying relative importance or implicitly specifying a quantity of the indicated technical features. Therefore, a feature defined by "first" or "second" may explicitly or implicitly include one or more of the features. In the description of the present invention, unless otherwise explicitly and specifically defined, "a plurality of" means two or more.

The load current measurement circuit and method for a Buck-type DC-DC converter provided in the present invention have been described in detail above. Any obvious change made by a person of ordinary skill in the art to the present invention without departing from the essence of the present invention shall constitute a violation of the patent right of the present invention and shall take corresponding legal responsibility.

**Claims**

1. A load current measurement circuit for a Buck-type DC-DC converter, comprising a switch current measurement unit, a freewheeling current compensation unit, and a signal averaging processing unit, wherein

   a first input end of the switch current measurement unit is coupled to an input voltage end, a second input end of the switch current measurement unit is coupled to a connection node between a power switch and a freewheeling diode, and the switch current measurement unit is configured to: when the power switch is turned on and the freewheeling diode is turned off, measure a power switch current and obtain a measured current proportional to the power switch current;

   a first input end of the freewheeling current compensation unit is coupled to an output voltage end, a second input end of the freewheeling current compensation unit is coupled to a ground potential end, and the freewheeling current compensation unit is configured to obtain, after processing the output voltage, a freewheeling diode compensation current proportional to an output voltage; and

   a first input end of the signal averaging processing unit is connected to an output end of the switch current measurement unit, a second input end of the signal averaging processing unit is connected to an output end of the freewheeling current compensation unit, and the signal averaging processing unit is configured to obtain a load current after performing averaging processing on the measured current and the compensation current.

2. The load current measurement circuit for a Buck-type DC-DC converter according to claim 1, wherein the switch current measurement unit comprises a first PMOS transistor, a second PMOS transistor, a third PMOS transistor, a fourth PMOS transistor, a fifth PMOS transistor, a sixth PMOS transistor, a first NMOS transistor, a second NMOS transistor, and a first inverter, wherein a source of the second PMOS transistor and a source of the third PMOS transistor are connected to the input voltage end, and a source of the first PMOS transistor is connected to the connection node between the power switch and the freewheeling diode; a gate of the first PMOS transistor is connected to a first control signal end and connected, through the first inverter, to a gate of the second PMOS transistor, a drain of the first PMOS transistor and a drain of the second PMOS transistor are connected to each other and then are jointly connected to a source of the fourth PMOS transistor, a drain of the fourth PMOS transistor is connected to a drain of the first NMOS transistor and a gate of the sixth PMOS transistor, a source of the first NMOS transistor is connected to the ground potential end, and a gate of the first NMOS transistor is connected to a bias voltage end; a gate of the fourth PMOS transistor is connected to a gate of the fifth PMOS transistor, the gate of the fifth PMOS transistor is short-circuited to a drain of the fifth PMOS transistor and then connected to a drain of the second NMOS transistor, a source of the second NMOS transistor is connected to the ground potential end, and a gate of the second NMOS transistor is connected to the bias voltage end; a source of the fifth PMOS transistor is connected to a drain of the third PMOS transistor and connected to a source of the sixth PMOS transistor; and a gate of the third PMOS transistor is connected to the ground potential end, and a drain of the sixth PMOS transistor is connected to the output end of the switch current measurement unit.

3. The load current measurement circuit for a Buck-type DC-DC converter according to claim 2, wherein

   the measured current Isen outputted by the switch current measurement unit satisfies the following formula:

   $$I_{sen} = K_1 * I_{P1}$$

   wherein $I_{P1}$ is the power switch current when the power switch is turned on, and $K_1$ is a power switch current measurement proportional coefficient.

4. The load current measurement circuit for a Buck-type DC-DC converter according to claim 1, wherein
   the freewheeling current compensation unit comprises a first operational amplifier, a seventh PMOS transistor, an eighth PMOS transistor, a third NMOS transistor, a fourth NMOS transistor, a fifth NMOS transistor, a first resistor, a second resistor, and a third resistor, wherein one end of the first resistor is connected to the output voltage end, the other end of the first resistor is connected to the second resistor and an in-phase input end of the first operational amplifier, and the other end of the second resistor is connected to the ground potential end; an output end of the first operational amplifier is connected to a gate of the third NMOS transistor, a reverse-phase input end of the first operational amplifier is connected to a source of the third NMOS transistor and the third resistor, and the other end of the third resistor is connected to the ground potential end; and a drain of the third NMOS transistor is connected to a drain of the seventh PMOS transistor, the drain of the seventh PMOS transistor is short-circuited to a gate of the seventh PMOS transistor and then connected to a gate of the eighth PMOS transistor, a source of the seventh PMOS transistor is connected to a source of the eighth PMOS transistor, a drain of the eighth PMOS transistor is connected to a drain of the fourth NMOS transistor, the drain of the fourth NMOS transistor is short-circuited to a gate of the fourth NMOS transistor and then connected to a gate of the fifth NMOS transistor, a source of the fourth NMOS transistor and a source of the fifth NMOS transistor are both connected to the ground potential end, and a drain of the fifth NMOS transistor is connected to the output end of the freewheeling current compensation unit.

5. The load current measurement circuit for a Buck-type DC-DC converter according to claim 4, wherein

   the compensation current Icomp outputted by the freewheeling current compensation unit satisfies the following formula:

   $$I_{comp} = K_2 * V_{out}$$

   wherein Vout is the output voltage, and $K_2$ is a proportional coefficient between the compensation current and the output voltage.

6. The load current measurement circuit for a Buck-type DC-DC converter according to claim 1, wherein

   the signal averaging processing unit comprises a sample-and-hold module, a unity gain buffer module, a low-pass filter module, a voltage-to-current conversion module, a first bias current source, and a second bias current source, wherein
   the sample-and-hold module generates a measured voltage according to the measured current, the compensation current, and a first bias current source current; after the measured voltage undergoes voltage buffering of the unity gain buffer module and low-pass filtering of the low-pass filter module, an average voltage is generated; and after the average voltage is converted into a current signal through the voltage-to-current conversion module, bias current information is removed through a second bias current source current, to obtain the load current.

7. The load current measurement circuit for a Buck-type DC-DC converter according to claim 6, wherein

in the signal averaging processing unit, the sample-and-hold module comprises a sampling resistor, a sampling capacitor, a first switch, and a second switch; the unity gain buffer module comprises a second operational amplifier; and the low-pass filter module comprises a filter resistor and a filter capacitor, wherein

the output end of the switch current measurement unit and an output end of the first bias current source are jointly connected to the sampling resistor and the first switch, and the other end of the sampling resistor is connected to the ground potential end; the other end of the first switch is connected to the sampling capacitor, the second switch, and an in-phase input end of the second operational amplifier, the other end of the sampling capacitor is connected to the ground potential end, and the other end of the second switch is connected to the output end of the freewheeling current compensation unit; a reverse-phase input end and an output end of the second operational amplifier are short-circuited and then are jointly connected to the filter resistor, the other end of the filter resistor is connected to the filter capacitor and an input end of the voltage-to-current conversion module, and the other end of the filter capacitor is connected to the ground potential end; and an output end of the voltage-to-current conversion module is connected to an input end of the second bias current source and an output end of the signal averaging processing unit, and an output end of the second bias current source is connected to the ground potential end; and

a control end of the first switch is connected to an inverted signal end of a first control signal, and a control end of the second switch is connected to a second control signal end.

8. The load current measurement circuit for a Buck-type DC-DC converter according to claim 6 or 7, wherein

when the power switch of the Buck-type DC-DC converter is turned on and the freewheeling diode of the Buck-type DC-DC converter is turned off, a change amount $\Delta V_{sen1}$ of the measured voltage outputted by the sample-and-hold module satisfies the following formula:

$$\Delta V_{sen1} = K_1 * \frac{V_{in} - V_{out}}{L} * D_1 * T_s * R_s$$

wherein $K_1$ is a power switch current measurement proportional coefficient, Rs is a resistance value of the sampling resistor, D1 is a duty cycle of the power switch, Ts is a switch cycle, Vin is an input voltage, Vout is the output voltage, and L is an inductance value of an inductor.

9. The load current measurement circuit for a Buck-type DC-DC converter according to claim 6 or 7, wherein

when the power switch of the Buck-type DC-DC converter is turned off and the freewheeling diode of the Buck-type DC-DC converter is turned on, a change amount $\Delta V_{sen2}$ of the measured voltage outputted by the sample-and-hold module satisfies the following formula:

$$\Delta V_{sen2} = \frac{K_2 * V_{out} * D_2 * T_s}{C_s}$$

wherein $K_2$ is a proportional coefficient between the compensation current and the output voltage, $D_2$ is a duty cycle of the freewheeling diode, Ts is a switch cycle, Cs is a capacitance value of the sampling capacitor, and Vout is the output voltage.

10. The load current measurement circuit for a Buck-type DC-DC converter according to any one of claims 2 to 9, wherein

the power switch current measurement proportional coefficient $K_1$ and the proportional coefficient $K_2$ between the compensation current and the output voltage satisfy the following formula:

$$K_2 = \frac{K_1 * C_s * R_s}{L}$$

wherein Cs is the capacitance value of the sampling capacitor, Rs is the resistance value of the sampling resistor, and L is the inductance value of the inductor.

11. The load current measurement circuit for a Buck-type DC-DC converter according to claim 6 or 7, wherein

in the signal averaging processing unit, an output current Ibias1 of the first bias current source and an output current Ibias2 of the second bias current source satisfy the following formula:

$$Ibias1*Rs*K3=Ibias2$$

wherein K3 is a conversion proportional coefficient of the voltage-to-current conversion module, and Rs is a resistance value of the sampling resistor.

12. A Buck-type DC-DC converter, comprising the load current measurement circuit according to any one of claims 1 to 11.

13. A load current measurement method for a Buck-type DC-DC converter, implemented based on the load current measurement circuit according to any one of claims 1 to 11, and comprising the following steps:

measuring a power switch current in a turn-on period of the power switch, to form a measured current;
generating, after sample-and-hold processing is performed on the measured current and a bias current source, a measured voltage proportional to an inductance current in an inductance current rising phase;
measuring an output voltage in a turn-on period of the freewheeling diode, to form a compensation current;
generating, after sample-and-hold processing is performed on the compensation current, the measured current, and the bias current source, a measured voltage proportional to the inductance current in an inductance current decreasing phase;
performing averaging processing on the measured voltage to obtain an average voltage; and
converting the average voltage into a current signal and then removing bias current information to obtain a load current.

FIG. 1

FIG. 2

FIG. 3

FIG. 4

FIG. 5

FIG. 6

FIG. 7

FIG. 8

FIG. 9

FIG. 10

FIG. 11

EP 4 697 032 A1

Measure a power switch current IP1 in a turn-on period of a power switch P1, to form a measured current Isen

Generate, after sample-and-hold processing is performed on the measured current Isen and a bias current source Ibias, a measured voltage Vsen proportional to an inductance current in an inductance current rising phase

Measure an output voltage Vout in a turn-on period of a freewheeling diode N1, to form a compensation current Icomp

Generate, after sample-and-hold processing is performed on the compensation current Icomp, the measured current Isen, and the bias current source Ibias, a measured voltage Vsen proportional to the inductance current in an inductance current decreasing phase

Perform averaging processing on the voltage Vsen to obtain an average voltage Vsen_ave

Convert the average voltage Vsen_ave into a current signal and then remove bias current information to obtain a load current Isen_ave

FIG. 12

## INTERNATIONAL SEARCH REPORT

| International application No. |
| --- |
| **PCT/CN2024/086573** |

| A. | CLASSIFICATION OF SUBJECT MATTER |
| --- | --- |

G01R19/00(2006.01)i; H02M3/156(2006.01)i

According to International Patent Classification (IPC) or to both national classification and IPC

| B. | FIELDS SEARCHED |
| --- | --- |

Minimum documentation searched (classification system followed by classification symbols)

IPC:G01R,H02M

Documentation searched other than minimum documentation to the extent that such documents are included in the fields searched

Electronic data base consulted during the international search (name of data base and, where practicable, search terms used)

CNTXT, ENTXTC, CNKI, ENTXT, VEN: 负载电流, 测, 开关管, 功率管, 续流管, 比例, 补偿, 输出电压, 平均, 反相器, 运算放大器, 采样电容, 偏置电流, Buck, DC-DC, load current, test, measure, detect, switch tube, power pipe, follow current tube, ratio, compensation, output voltage, average, bias current, NMOS, PMOS

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116520003 A (VANCHIP (TIANJIN) ELECTRONIC TECHNOLOGY CO., LTD.) 01 August 2023 (2023-08-01) <br> claims 1-13, and description, paragraphs 0004-0131 | 1-13 |
| X | CN 107659151 A (SHENZHEN HOTCHIP TECHNOLOGY CO., LTD.) 02 February 2018 (2018-02-02) <br> description, paragraphs 0002-0054, and figures 2-3 and 5 | 1-5, 10, 12 |
| Y | CN 107659151 A (SHENZHEN HOTCHIP TECHNOLOGY CO., LTD.) 02 February 2018 (2018-02-02) <br> description, paragraphs 0002-0054, and figures 2-3 and 5 | 6-9, 11, 13 |
| Y | CN 102981032 A (SHENZHEN BOCHIXIN ELECTRONICS CO., LTD.) 20 March 2013 (2013-03-20) <br> description, paragraphs 0028-0039, and figures 4-5 and 7 | 6-9, 11, 13 |
| X | CN 110943612 A (SHENZHEN HOTCHIP TECHNOLOGY CO., LTD.) 31 March 2020 (2020-03-31) <br> description, paragraphs 0008-0057, and figures 1 and 6-7 | 1-5, 10, 12 |

| ✓ Further documents are listed in the continuation of Box C. | ✓ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **28 July 2024** | **02 August 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| | International application No. |
|---|---|
| | **PCT/CN2024/086573** |

### C.    DOCUMENTS CONSIDERED TO BE RELEVANT

| Category* | Citation of document, with indication, where appropriate, of the relevant passages | Relevant to claim No. |
|---|---|---|
| X | CN 107656123 A (SHENZHEN HOTCHIP TECHNOLOGY CO., LTD.) 02 February 2018 (2018-02-02)<br>    description, paragraphs 0006-0036, and figures 3 and 5 | 1-5, 10, 12 |
| A | CN 110957894 A (SHENZHEN HOTCHIP TECHNOLOGY CO., LTD.) 03 April 2020 (2020-04-03)<br>    entire document | 1-13 |
| A | CN 104101764 A (JINAN UNIVERSITY) 15 October 2014 (2014-10-15)<br>    entire document | 1-13 |
| A | CN 104407659 A (SILERGY SEMICONDUCTOR TECHNOLOGY (HANGZHOU) CO., LTD.) 11 March 2015 (2015-03-11)<br>    entire document | 1-13 |
| A | CN 107656124 A (SHENZHEN HOTCHIP TECHNOLOGY CO., LTD.) 02 February 2018 (2018-02-02)<br>    entire document | 1-13 |
| A | CN 115705066 A (ON-BRIGHT INTEGRATED CIRCUIT (XI'AN) CO., LTD.) 17 February 2023 (2023-02-17)<br>    entire document | 1-13 |
| A | US 9941795 B1 (DIALOG SEMICONDUCTOR (UK) LTD.) 10 April 2018 (2018-04-10)<br>    entire document | 1-13 |

Form PCT/ISA/210 (second sheet) (July 2022)

24

## INTERNATIONAL SEARCH REPORT
### Information on patent family members

International application No.

**PCT/CN2024/086573**

| Patent document cited in search report | | | Publication date (day/month/year) | Patent family member(s) | | | Publication date (day/month/year) |
|---|---|---|---|---|---|---|---|
| CN | 116520003 | A | 01 August 2023 | None | | | |
| CN | 107659151 | A | 02 February 2018 | None | | | |
| CN | 102981032 | A | 20 March 2013 | None | | | |
| CN | 110943612 | A | 31 March 2020 | None | | | |
| CN | 107656123 | A | 02 February 2018 | None | | | |
| CN | 110957894 | A | 03 April 2020 | None | | | |
| CN | 104101764 | A | 15 October 2014 | None | | | |
| CN | 104407659 | A | 11 March 2015 | None | | | |
| CN | 107656124 | A | 02 February 2018 | None | | | |
| CN | 115705066 | A | 17 February 2023 | None | | | |
| US | 9941795 | B1 | 10 April 2018 | DE | 102017212837 | A1 | 25 October 2018 |
| | | | | DE | 102017212837 | B4 | 19 May 2022 |

Form PCT/ISA/210 (patent family annex) (July 2022)